Europäisches Patentamt

European Patent Office

Office européen des brevets

(11) Numéro de publication : **0 613 251 A1**

# (12) DEMANDE DE BREVET EUROPEEN

(21) Numéro de dépôt : **94400376.3**

(51) Int. Cl.$^5$ : **H03K 21/38, H03K 23/66**

(22) Date de dépôt : **22.02.94**

(30) Priorité : **26.02.93 FR 9302231**

(43) Date de publication de la demande :
**31.08.94 Bulletin 94/35**

(84) Etats contractants désignés :
**BE DE FR GB IT NL**

(71) Demandeur : **THOMSON-CSF
SEMICONDUCTEURS SPECIFIQUES
173, Boulevard Haussmann
F-75008 Paris (FR)**

(72) Inventeur : **Ferrant, Richard
THOMSON-CSF,
SCPI,
B.P. 329
F-92402 Courbevoie Cédex (FR)**

(74) Mandataire : **Guérin, Michel et al
THOMSON-CSF
SCPI
B.P. 329
50, rue Jean-Pierre Timbaud
F-92402 Courbevoie Cédex (FR)**

(54) **Diviseur de fréquence.**

(57)    L'invention concerne un diviseur de fréquence constitué de N diviseurs par 2. Selon l'invention, le diviseur de fréquence comprend des circuits logiques permettant de générer le signal de fin de division de fréquence à l'aide du changement d'état du bit de poids fort généré par le diviseur par 2 de rang N.

Un code binaire C représentant une valeur entière décimale V est appliqué au circuit diviseur. Selon l'invention, le diviseur de fréquence comprend des circuits qui permettent de réaliser une division de rang variable (V+1, V, ... V-p où p est un nombre entier supérieur ou égal à 1) pour un même code binaire C.

EP 0 613 251 A1

Jouve, 18, rue Saint-Denis, 75001 PARIS

La présente invention concerne un circuit diviseur de fréquence.

Les circuits diviseurs de fréquence sont utilisés dans de nombreux dispositifs tels que, par exemple, les circuits de comptage, les boucles de phase, les synthétiseurs de fréquence ou encore les circuits de cryptage d'informations.

L'invention sera plus particulièrement décrite pour la réalisation de circuits de comptage mais concerne, de façon plus générale, tous les domaines où interviennent les diviseurs de fréquence.

Les circuits de comptage sont de deux types. Il y a les compteurs asynchrones et les compteurs synchrones. L'invention concerne plus particulièrement les compteurs synchrones mais peut aussi concerner les compteurs asynchrones.

Les compteurs synchrones à N bits peuvent générer $2^N$ combinaisons différentes.

Leur remise à zéro s'effectue automatiquement lors du dépassement de capacité, c'est-à-dire au $2^{N \text{ième}}$ coup d'horloge. On dit alors que l'on divise la fréquence par $2^N$.

Il est souvent nécessaire de diviser par un nombre n quelconque avant d'atteindre le $2^{N \text{ième}}$ coup d'horloge. Selon l'art antérieur, le circuit de comptage comprend alors des fonctions logiques supplémentaires permettant d'effectuer la remise à zéro, ou reset, au moment souhaité. Chaque code généré par le compteur est comparé à un même mot logique. De la comparaison entre les codes et le mot logique est issu un signal qui autorise la division de fréquence au rang n souhaité. La comparaison entre les codes et le mot logique nécessite la présence d'un circuit de multiplexage qui devient rapidement complexe dès que le nombre de bits N croît. Ce circuit de multiplexage prend alors beaucoup de place.

Un inconvénient du dispositif selon l'art antérieur est donc de nécessiter un circuit encombrant dont la gestion est d'autant plus complexe que l'on désire changer fréquemment la valeur de n. Ceci est très pénalisant, par exemple, en ce qui concerne les boucles de phase où il est nécessaire de diviser très fréquemment une fréquence de référence par un nombre n variable.

La présente invention ne présente pas cet inconvénient.

La présente invention a pour objet un diviseur de fréquence constitué d'un nombre entier N de diviseurs par 2, chaque diviseur par 2 permettant de générer un bit $b_i$, caractérisé en ce qu'il comprend des circuits logiques permettant de générer le signal de fin de division de fréquence à l'aide du changement d'état du bit de poids fort généré par le diviseur par 2 de rang N.

Un avantage de l'invention est donc de simplifier le circuit de division de fréquence et, partant, la gestion de celui-ci.

D'autres caractéristiques et avantages de l'invention apparaîtront à la lecture d'un mode de réalisation préférentiel fait avec référence aux figures ci-annexées dans lesquelles :
- la figure 1 représente le schéma synoptique d'un circuit de comptage selon l'art antérieur.
- les figures 2A et 2B représentent un circuit de comptage selon un premier mode de réalisation de l'invention.
- les figures 3A et 3B représentent un circuit de comptage selon le mode de réalisation préférentiel de l'invention.

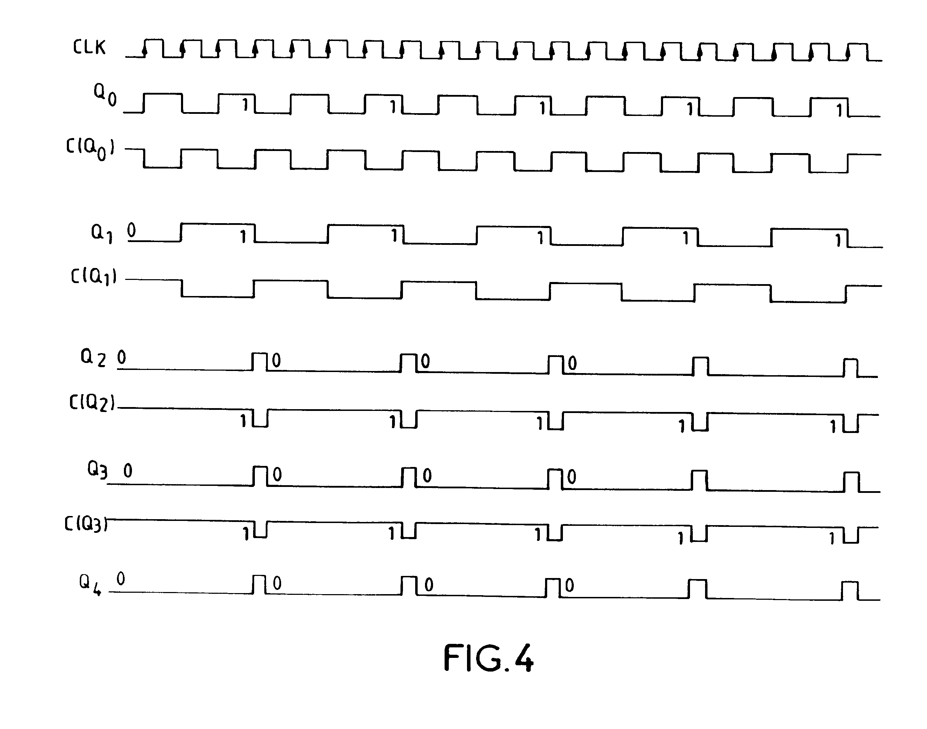

- la figure 4 représente le chronogramme d'un circuit de comptage selon un exemple de réalisation de l'invention.

Sur toutes les figures, les mêmes repères désignent les mêmes éléments.

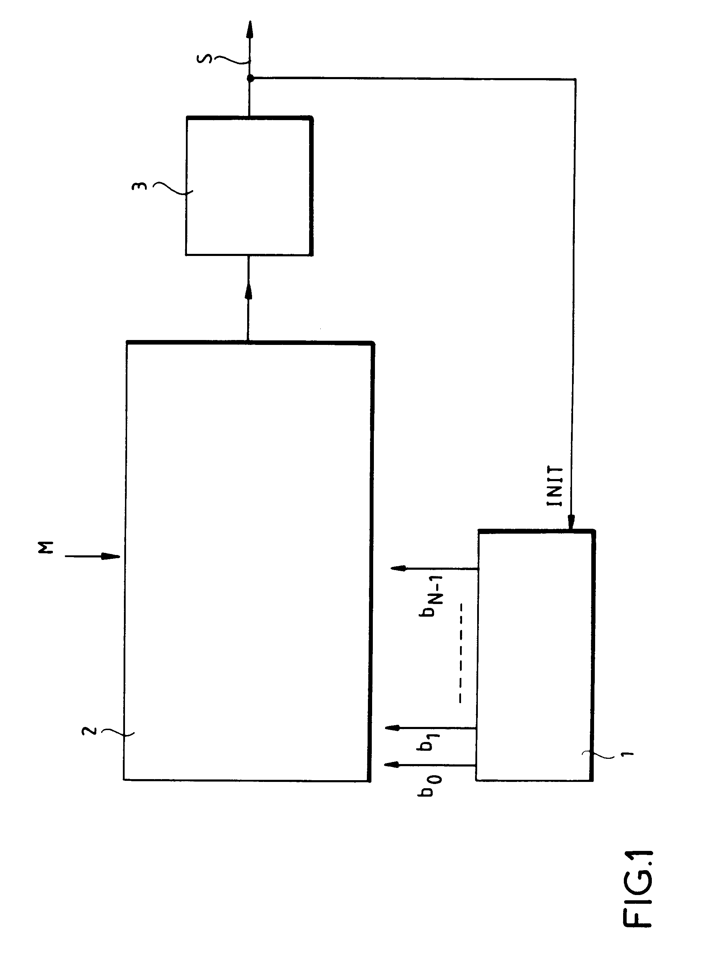

La figure 1 représente le schéma synoptique d'un dispositif de comptage selon l'art antérieur.

Le compteur 1 génère un code binaire de N bits $(b_0, b_1, ... b_{N-1})$ sous l'action d'un signal d'horloge non représenté sur la figure. Le code $(b_0, b_1, ..., b_{N-1})$ est envoyé dans un dispositif de multiplexage 2 qui reçoit, par ailleurs, un mot logique M. Ce mot logique représente, en code binaire, le nombre n-1, n étant le nombre par lequel on désire diviser la fréquence. Quand le code $(b_0, b_1, ... b_{N-1})$ correspond au mot binaire M, le multiplexeur 2 génère un signal qui est envoyé dans une bascule bistable 3.

Au $n^{\text{ième}}$ coup d'horloge, le signal de sortie S de la bascule 3 est réinjecté dans le compteur 1 de façon à constituer le signal INIT qui permet de remettre le compteur dans son état de départ.

Comme cela est connu de l'homme de l'art, le fait d'identifier le code (n-1) et non n permet d'éviter tout risque d'aléa.

Comme cela a été mentionné précédemment, un tel dispositif est très encombrant aussi bien à cause de la présence du multiplexeur 2 que de celle de la bascule 3. L'invention ne présente pas une telle complexité.

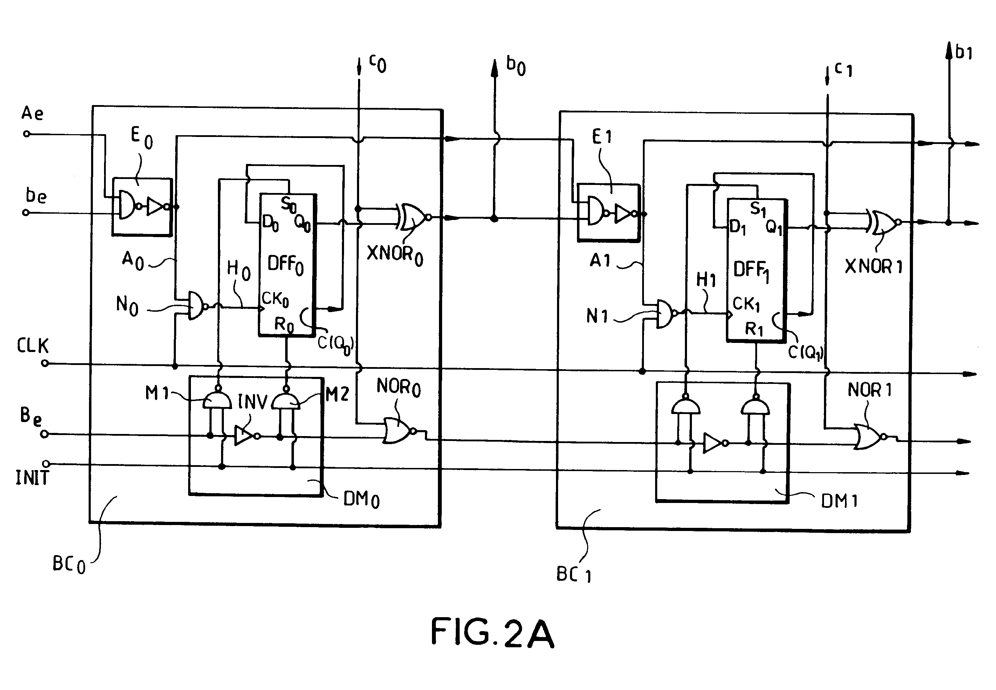

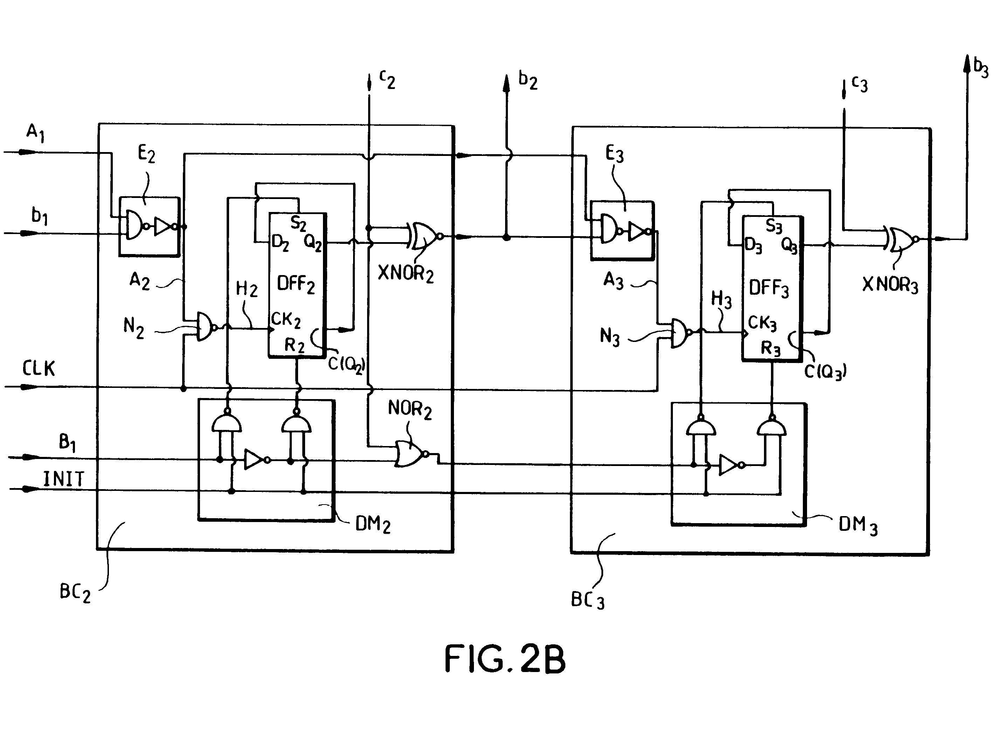

Les figures 2A et 2B représentent un circuit de comptage selon un premier mode de réalisation de l'invention.

Pour des raisons de clarté le même circuit a été représenté sur 2 feuilles différentes. Ce circuit est un compteur à 4 bits $(b_0, b_1, b_2, b_3)$ mais l'invention concerne aussi les compteurs à N bits ou N est un nombre entier quelconque. C'est pour des raisons de commodité que l'exemple choisi correspond à N = 4.

Le circuit représenté par les figures 2A et 2B comprend 4 blocs de comptage $BC_0$, $BC_1$, $BC_2$, $BC_3$, chacun

délivrant un bit, soit respectivement $b_0$, $b_1$, $b_2$, $b_3$. Selon l'invention, chaque bit $b_i$ est issu d'un circuit logique "ou exclusif complémentaire" $XNOR_i$. Chaque circuit $XNOR_i$ a une première entrée reliée à la sortie $Q_i$ d'un diviseur par 2, DFFi, et une deuxième entrée reliée à un bit de consigne $C_i$.

Il vient donc :

$b_i = C_i \cdot Q_i + C(C_i) \cdot C(Q_i)$.

Dans l'équation ci-dessus, les symboles "." et "+" représentent respectivement les opérations mathématiques booléennes de multiplication et d'addition et C (X) représente la variable qui a pour valeur le niveau logique complémentaire du niveau logique de la variable X.

Il vient donc :

$b_i = Q_i$ pour $C_i = 1$.

et

$b_i = C(Q_i)$ pour $C_i = 0$

Sur les figures 2A et 2B, les diviseurs par 2 sont des bascules D. Cependant, l'invention concerne également des diviseurs par 2 constitués, par exemple, de bascules J/K ou de bascules RS.

Selon l'invention, la sortie $Q_i$ de chaque diviseur DFFi bascule, par exemple, sur le front montant du signal d'horloge Hi qui est appliqué à son entrée d'horloge $CK_i$, à la condition que tous les bits $b_j$ (j = 0, 1,..., i-1) issus des blocs de comptage précédents soient égaux à 1.

A cette fin, chaque signal d'horloge Hi est issu d'un circuit logique "non et", Ni, sur lequel sont appliqués, d'une part, un signal d'horloge extérieure CLK et, d'autre part, un signal $A_i$ égal à 1 si et seulement si tous les $b_j$ (j = 0, 1, ..., i-1) sont égaux à 1. Le signal $A_i$ est issu d'un circuit "et", Ei, et a pour valeur $A_i = A_{i-1} \cdot b_{i-1}$. Afin d'initialiser le dispositif, deux signaux extérieurs $A_e$ et $b_e$, tous deux égaux à 1, sont envoyés sur le bloc de comptage $BC_0$.

Pour des raisons de simplification, les circuits logiques décrits sont en logique négative laquelle utilise des circuits "non et". Cependant, l'invention concerne aussi l'utilisation d'une logique positive. Il suffit alors de changer les fonctions "non et" en fonctions "et" partout où cela est nécessaire. Les diviseurs DFFi basculent alors sur le front descendant du signal d'horloge $H_i$.

Chaque diviseur DFFi comprend une commande de set Si et une commande de reset Ri.

Les bits de set et de reset appliqués à chaque diviseur DFFi sont issus d'un démultiplexseur DMi, lequel reçoit d'une part le signal INIT qui permet d'initialiser chaque bloc de comptage et d'autre part un signal de contrôle $B_{i-1}$ qui permet de rendre actif ou non le signal INIT sur les plots Si et Ri.

Chaque démultiplexeur DMi est constitué de deux circuits "non et", M1 et M2, et d'un circuit inverseur INV. Un premier circuit "non et", par exemple M1, a sa sortie reliée au plot de set Si et un deuxième circuit "non et", par exemple M2, a sa sortie reliée au plot de reset $R_i$. Chaque circuit "non et" possède 2 entrées dont l'une reçoit le signal INIT et l'autre soit le signal de contrôle $B_{i-1}$ pour M1, soit le signal complémentaire de $B_{i-1}$ pour M2.

L'inverseur INV permet de passer le signal INIT soit vers Si, soit vers Ri.

Chaque bloc de comptage $BC_i$ comprend aussi un circuit NORi assurant la fonction logique "non ou" et destiné à détecter que le bit de consigne $C_i$ passe 1. Lors du passage à 1 du bit de consigne Ci, la sortie du circuit NORi passe à zéro, rendant actif le reset et donc inactif le set du bloc de comptage de rang i+1. A cette fin, et de façon générale, le signal de sortie du circuit NORi constitue le signal de contrôle $B_{i+1}$. Le signal de contrôle envoyé dans le démultiplexeur $DM_o$ est un signal extérieur noté Be.

La combinaison des bits de consigne $C_i$ constitue un code binaire C. Ce code représente une valeur entière décimale V codée en binaire. Quand le bit de contrôle Be est égal à 0, les bits de set et de reset appliqués à chaque diviseur DFFi sont respectivement égaux à 1 et 0 lorsque le bit d'initialisation INIT passe à 1. Toutes les sorties Qi sont alors mises à zéro et le diviseur selon l'invention effectue une division par V+1.

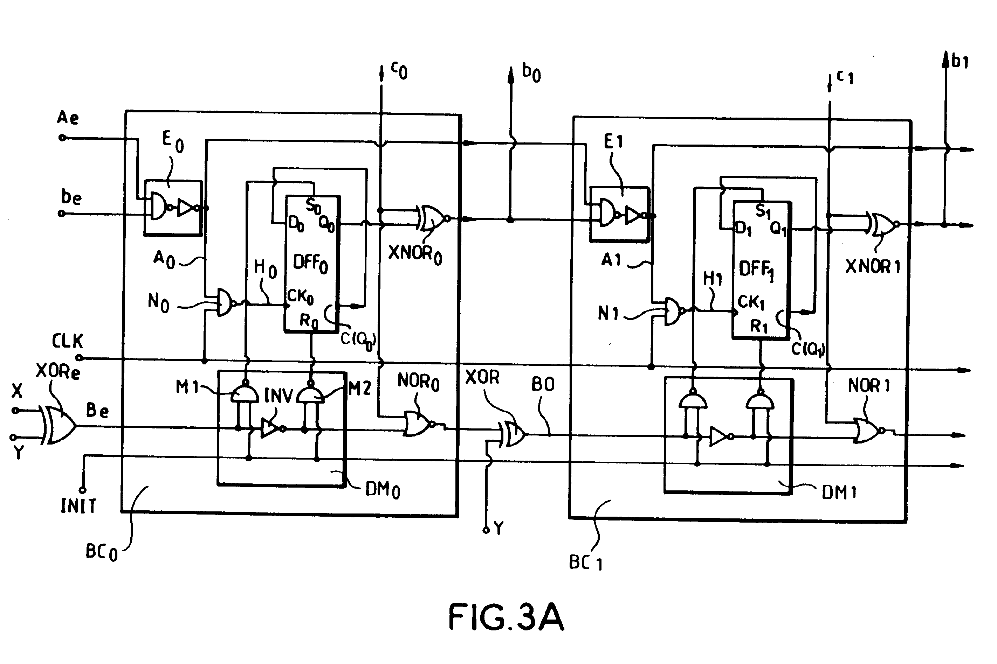

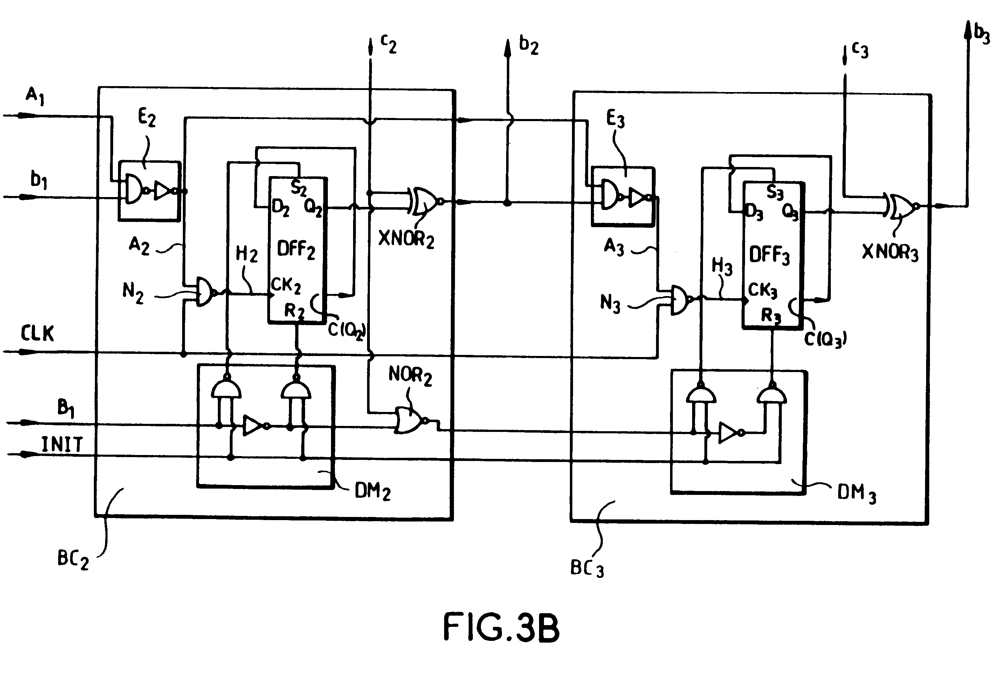

Les figures 3A et 3B représentent un circuit de comptage selon le mode de réalisation préférentiel de l'invention. Le dispositif selon le mode de réalisation préférentiel de l'invention permet de diviser par V+1, V ou V-1 selon les niveaux logiques appliqués aux commandes de set et de reset. A cette fin, deux fonctions logiques supplémentaires font partie du dispositif.

Une première fonction logique "non ou" $XOR_e$ génère le signal de contrôle Be à partir de deux signaux de commande X et Y. Il vient $Be = X \cdot Y + X \cdot Y$.

Une deuxième fonction logique "non ou" XOR génère le signal de contrôle $B_o$ à partir d'une part du signal issu du circuit NORo et d'autre part du signal de commande Y.

On retrouve les conditions d'une division par V+1 pour X = 0 et Y = 0.

Le tableau ci-dessous donne, en fonction du code C, les niveaux logiques qui sont appliqués aux plots de reset $R_i$ afin de réaliser une division par V. L'exemple choisi est celui du compteur à 4 bits.

| Code C | | | | Logique de reset | | | |
|---|---|---|---|---|---|---|---|
| C3 | C2 | C1 | C0 | R3 | R2 | R1 | R0 |
| 0 | 0 | 0 | 0 | 1 | 1 | 1 | 1 |
| 0 | 0 | 0 | 1 | 0 | 0 | 0 | 1 |
| 0 | 0 | 1 | 0 | 0 | 0 | 1 | 1 |
| 0 | 1 | 1 | 0 | 0 | 0 | 0 | 1 |
| 0 | 1 | 0 | 0 | 0 | 1 | 1 | 1 |
| 0 | 1 | 0 | 1 | 0 | 0 | 0 | 1 |
| 0 | 1 | 1 | 0 | 0 | 0 | 1 | 1 |
| 0 | 1 | 1 | 1 | 0 | 0 | 0 | 1 |
| 1 | 0 | 0 | 0 | 1 | 1 | 1 | 1 |
| 1 | 0 | 0 | 1 | 0 | 0 | 0 | 1 |
| 1 | 0 | 1 | 0 | 0 | 0 | 1 | 1 |
| 1 | 0 | 1 | 1 | 0 | 0 | 0 | 1 |
| 1 | 1 | 0 | 0 | 0 | 1 | 1 | 1 |
| 1 | 1 | 0 | 1 | 0 | 0 | 0 | 1 |
| 1 | 1 | 1 | 0 | 0 | 0 | 1 | 1 |
| 1 | 1 | 1 | 1 | 0 | 0 | 0 | 1 |

Selon ce mode de fonctionnement, la sortie $Q_0$ est initialisée à 1 de façon à permettre à la sortie $Q_1$ de commuter dès le premier coup d'horloge.

Lorsque tous les bits du code de consigne C sont égaux à 0, toutes les commandes de reset sont à 1 et donc toutes les commandes de set à 0 sur les différents diviseurs DFFi. Dès qu'un bit de consigne $C_i$ prend la valeur 1, les commandes de reset des diviseurs de rang supérieur à i sont portées à zéro.

$B_e$ doit donc être égal à 1 et Y doit être égal à 0. Il vient donc X = 1 dans ce cas.

Le tableau ci-dessous donne, en fonction du code C, les niveaux logiques qui sont appliqués aux plots de reset $R_i$ afin de réaliser une division par V - 1. L'exemple choisi est toujours celui du compteur à 4 bits.

| Code C | | | | Logique de reset | | | |
|---|---|---|---|---|---|---|---|
| C3 | C2 | C1 | C0 | R3 | 2 | R1 | R0 |
| 0 | 0 | 0 | 0 | 1 | 1 | 1 | 0 |
| 0 | 0 | 0 | 1 | 1 | 1 | 1 | 0 |
| 0 | 0 | 1 | 0 | 0 | 0 | 1 | 0 |
| 0 | 0 | 1 | 1 | 0 | 0 | 1 | 0 |
| 0 | 1 | 0 | 0 | 0 | 1 | 1 | 0 |
| 0 | 1 | 0 | 1 | 0 | 1 | 1 | 0 |
| 0 | 1 | 1 | 0 | 0 | 0 | 1 | 0 |
| 0 | 1 | 1 | 1 | 0 | 0 | 1 | 0 |
| 1 | 0 | 0 | 0 | 1 | 1 | 1 | 0 |
| 1 | 0 | 0 | 1 | 1 | 1 | 1 | 0 |
| 1 | 0 | 1 | 0 | 0 | 0 | 1 | 0 |
| 1 | 0 | 1 | 1 | 0 | 0 | 1 | 0 |
| 1 | 1 | 0 | 0 | 0 | 1 | 1 | 0 |
| 1 | 1 | 0 | 1 | 0 | 1 | 1 | 0 |
| 1 | 1 | 1 | 0 | 0 | 0 | 1 | 0 |
| 1 | 1 | 1 | 1 | 0 | 0 | 1 | 0 |

Selon ce mode de fonctionnement, les deux premiers blocs de comptage reçoivent une initialisation différentes des autres blocs.

Pour le premier diviseur $DFF_0$, la commande de reset $R_0$ est égale à O de façon à imposer à $Q_0$ la valeur 0. Pour le deuxième diviseur $DFF_1$, la commande de reset $R_1$ est égale à 1 de façon à imposer à $Q_1$ la valeur 1.

Les signaux $B_e$, Y et X doivent alors prendre les valeurs suivantes :

$B_e = 0$ ; $Y = 1$ ; $X = 1$ .

De même que précédemment, les commandes de reset des diviseurs de rang supérieur à i sont portées à zéro lorsqu'un bit de consigne $C_i$ prend la valeur 1.

Quel que soit le mode de fonctionnement (division par V+1, V ou V-1) le signal autorisant l'arrêt du comptage est donné par le changement d'état du bit de poids fort $b_{N-1}$ généré par le bloc de comptage $BC_N$. Le signal qui indique la fin du comptage est donc généré par le même bit quel que soit le rang de la division.

L'invention permet donc la suppression de la logique de multiplexage qui est nécessaire, selon l'art antérieur, pour récupérer le code indiquant la fin du comptage. Cette logique de multiplexage est très encombrante. Le gain en surface qui résulte de sa suppression est un avantage de l'invention.

Un autre avantage de l'invention est la suppression du risque d'aléa logique puisque le signal qui indique la fin du comptage est unique et apparaît avec le délai intrinsèque du diviseur $DFF_N$.

Le mode de réalisation qui vient d'être décrit est le mode de réalisation préférentiel de l'invention.

Avantageusement, la présence des circuits XOR et $XOR_e$ permet, pour un même code C, de faire varier le rang de la division de fréquence. En effet, selon les signaux de commande X et Y appliqués aux circuits XOR et $XOR_e$, la division de fréquence est de rang V+1, V ou V-1.

L'invention concerne d'autres modes de réalisation. Selon ces modes de réalisation des circuits du même type que le circuit XOR sont ajoutés au dispositif de façon à permettre, pour un même code C, une division de fréquence de rang V+1, V,... ou V-p, p étant un nombre entier compris entre 1 et N-1.

La bascule bistable 3, indispensable selon l'art antérieur pour éviter tout risque d'aléa, n'est donc plus nécessaire dans le dispositif selon l'invention.

Le gain de place que procure le dispositif selon l'invention permet de multiplier dans des proportions importantes le nombre de blocs de comptage. Ainsi un circuit selon l'invention peut-il générer, à encombrement équivalent, beaucoup plus de bits qu'un circuit selon l'art antérieur.

En particulier, en ce qui concerne les boucles de phase, le très grand nombre de rangs de comptage (de l'ordre de deux à plusieurs centaines) entraîne, selon l'art antérieur, une très grande complexité des circuits logiques. L'invention permet de réduire considérablement cette complexité, permettant ainsi d'étendre le domaine d'application des boucles de phase (circuits de plus grande surface et nombre de modes de fonctionnement plus élevé).

L'invention concerne un circuit de comptage à rang variable, comme cela a été décrit précédemment.

Cependant l'invention concerne aussi un circuit de comptage à rang fixe. La logique de câblage est alors encore plus simple. Les circuits $XNOR_i$ sont supprimés de façon à câbler directement les sorties $Q_i$ ou $C(Q_i)$ et les circuits de la logique de set et de reset sont simplifiés de façon à afficher les seuls bits de commande utiles.

Si le signal indiquant la fin de l'opération de division de fréquence n'est pas réinjecté sur la commande INIT le circuit selon l'invention n'est plus un diviseur de fréquence mais un générateur de délais binaires. Le délai est alors égal à V+1, V ou V-1 coups d'horloge. L'invention concerne aussi ce type de dispositif .

La figure 3 représente le chronogramme d'un circuit de division par 4, selon un exemple de réalisation du mode de réalisation préférentiel de l'invention.

Selon cet exemple de réalisation, la division par 4 est du type division par V + 1.

Ainsi la remise à zéro est-elle effectuée lorsque la valeur V du code C en décimal est égale à 3, soit

$C3 = 0$ $\qquad$ $C2 = 0$ $\qquad$ $C1 = 1$ $\qquad$ $C0 = 1$

Il vient donc :

$b_0 = C_0.Q_0 + C(C_0).C(Q_0)$ ==> $b_0 = Q_0$

$b_1 = C_1.Q_1 + C(C_1).C(Q_1)$ ==> $b_1 = Q_1$

$b_2 = C_2.Q_2 + C(C_2).C(Q_2)$ ==> $b_2 = C(Q_2)$

$b_3 = C_3.Q_3 + C(C_3).C(Q_3)$ ==> $b_3 = C(Q_3)$

On constate qu'au troisième coup d'horloge tous les bits $b_i$ (i = 0, 1, 2, 3) sont égaux à 1 et qu'il y a une remise à zéro de tous les $Q_i$ au quatrième coup d'horloge.

## Revendications

1. Diviseur de fréquence comprenant un nombre entier N de diviseurs par 2 (DFFi), chaque diviseur par 2 permettant de générer un bit $b_i$ (i: 0,1,2,...,N-1), et des moyens (2, 3, DMi, $NOR_i$ $N_i$) permettant de diviser la fréquence sous l'action d'un code binaire (C) appliqué audit diviseur, le code binaire (M, C) représentant une valeur entière décimale (V), caractérisé en ce que lesdits moyens ($DM_i$, $NOR_i$, $N_i$, $XNOR_i$) sont constitués de circuits logiques ($DM_i$, $NOR_i$, $N_i$, $XNOR_i$) permettant de générer le signal de fin de division de fréquence à l'aide du changement d'état du bit ($b_{N-1}$) de poids fort généré par le diviseur par 2 de rang N.

2. Diviseur de fréquence selon la revendication 1, caractérisé en ce que lesdits circuits logiques sont des circuits de logique positive ou des circuits de logique négative.

3. Diviseur de fréquence selon la revendication 2, caractérisé en ce que lesdits circuits logiques ($DM_i$, $NOR_i$, $N_i$, $XNOR_i$) sont constitués de premiers circuits ($N_i$, $XNOR_i$) permettant à chaque diviseur par 2 de rang k (k = 1, 2,...,N) de basculer si et seulement si les bits issus de tous les diviseurs de rang inférieur à k ($b_o$, $b_1$,...$b_{k-1}$) sont égaux à 1 en logique négative ou à O en logique positive et de seconds circuits ($DM_i$, $NOR_i$, XOR, $XOR_e$) permettant d'appliquer sur les plots de set (Si) et de reset (Ri) de chaque diviseur par 2 ($DFF_i$) les signaux nécessaires à l'initialisation dudit diviseur par 2 (DFFi), sous l'action d'un signal d'initialisation (INIT).

4. Diviseur de fréquence selon la revendication 3, caractérisé en ce que les premiers circuits ($N_i$, $XNOR_i$) sont constitués d'un premier circuit logique ($N_i$) délivrant le signal d'horloge ($H_i$) appliqué à un diviseur par 2, ledit premier circuit logique recevant d'une part un signal d'horloge extérieure (CLK) et d'autre part un signal ($A_i$) égal à 1 en logique négative si et seulement si tous les bits $b_j$ (j = 0, 1,..., i-1) sont égaux à 1 ou égal à 0 en logique positive si et seulement si tous les bits $b_j$ (j = 0, 1,..., i-1) sont égaux à 0, et d'un deuxième circuit logique ($XNOR_i$) générant chaque bit $b_i$ (i = 0, 1, 2, ..., N-1) à partir du signal issu de la sortie ($Q_i$) du diviseur par 2 de rang i ($DFF_i$) et du bit de consigne de même rang Ci du code binaire appliqué (C), et en ce que les seconds circuits ($DM_i$, $NOR_i$, XOR, $XOR_e$) sont constitués d'un démultiplexeur ($DM_i$)

recevant un signal de contrôle (Bi) permettant de rendre actif le signal d'initialisation (INIT) sur le plot de set ou sur le plot de reset du diviseur par 2 de rang i, d'un circuit ($NOR_i$) destiné à détecter que le bit de consigne $C_i$ passe à 1 en logique négative ou à 0 en logique positive, et de moyens ($XOR_e$, XOR) permettant de modifier le signal de contrôle (Bi) appliqué à chaque diviseur par 2 ($DFF_i$) de façon à permettre, pour un même code binaire (C), une division de rang variable (V+1, V, ... V-p, ou p est un entier supérieur ou égal à 1 et inférieur à N-1) sous l'action de signaux de commande extérieurs (X, Y).

5. Diviseur de fréquence selon la revendication 4, caractérisé en ce que les diviseurs par 2 sont des bascules D, des bascules J/K ou des bascules RS.

6. Circuit de comptage, caractérisé en ce qu'il contient un diviseur de fréquence selon l'une quelconque des revendications précédentes.

7. Boucle de phase, caractérisée en ce qu'elle contient un diviseur de fréquence selon l'une quelconque des revendications 1 à 6.

8. Synthétiseur de fréquence, caractérisé en ce qu'il contient un diviseur de fréquence selon l'une quelconque des revendications 1 à 6.

FIG.1

FIG.2A

9

FIG.2B

FIG.3A

EP 0 613 251 A1

FIG.3B

EP 0 613 251 A1

FIG.4

EP 0 613 251 A1

**Office européen des brevets**

## RAPPORT DE RECHERCHE EUROPEENNE

Numero de la demande

EP 94 40 0376

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | PATENT ABSTRACTS OF JAPAN vol. 14, no. 463 (E-0988) 8 Octobre 1990 & JP-A-21 089 026 (MITSUBISHI ELECTRIC CORP.) 25 Juillet 1990 * abrégé * | 1 | H03K21/38 H03K23/66 |

**DOMAINES TECHNIQUES RECHERCHES (Int.Cl.5)**

H03K

Le présent rapport a été établi pour toutes les revendications

| Lieu de la recherche | Date d'achèvement de la recherche | Examinateur |
|---|---|---|
| LA HAYE | 31 Mai 1994 | Feuer, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)